# EUROPEAN PATENT SPECIFICATION

(11) **EP 3 961 667 B1**
(45) Date of publication and mention of the grant of the patent: **08.01.2025**
(21) Application number: 20192871.0
(22) Date of filing: 26.08.2020
(51) Int. Cl.: H01G 11/28, H01M 4/133, C01B 32/16, H01M 10/0525, C01B 25/00, H01G 11/36, C01B 32/162, C01B 32/168, C23C 8/02, C23C 8/08, C23C 8/80, C23C 16/26, C23C 16/56, H01J 37/32, H01M 4/136, H01M 4/1397, H01M 4/58, H01M 4/62, H01M 4/66

(54) **METHOD FOR MANUFACTURING HYBRID BINDER-FREE ELECTRODES FOR ELECTROCHEMICAL ENERGY STORAGE DEVICES**
VERFAHREN ZUR HERSTELLUNG VON HYBRIDEN BINDEMITTELFREIEN ELEKTRODEN FÜR ELEKTROCHEMISCHE ENERGIESPEICHERVORRICHTUNGEN
PROCÉDÉ DE FABRICATION D'ÉLECTRODES HYBRIDES SANS LIANT POUR DISPOSITIFS DE STOCKAGE D'ÉNERGIE ÉLECTROCHIMIQUE

(43) Date of publication of application: 02.03.2022
(73) Proprietor: Jozef Stefan Institute, 1000 Ljubljana (SI)
(72) Inventor: Marath Santhosh, Neelakandan, 1000 Ljubljana (SI); Filipic, Gregor, 1000 Ljubljana (SI); Zavasnik, Janez, 1000 Ljubljana (SI); Cvelbar, Uros, 1000 Ljubljana (SI)
(74) Representative: Nederlandsch Octrooibureau

(56) References cited:
- CN-A- 109 872 881
- CN-A- 110 033 959
- RU-C1- 2 660 819
- US-A1- 2004 241 532
- US-A1- 2011 204 020
- US-A1- 2013 074 771
- US-A1- 2014 349 216
- CHOI BONG GILL ET AL: "High-performance pseudocapacitor electrodes based on the flower-like nickel sulfide coated carbon nanofiber webs", MICROELECTRONIC ENGINEERING, ELSEVIER PUBLISHERS BV., AMSTERDAM, NL, vol. 222, 31 December 2019 (2019-12-31), XP085979137, ISSN: 0167-9317, [retrieved on 20191231], DOI: 10.1016/J.MEE.2019.111205
- KUMAR SACHIN ET AL: "0D to 3D carbon-based networks combined with pseudocapacitive electrode material for high energy density supercapacitor: A review", CHEMICAL ENGENEERING JOURNAL, ELSEVIER, AMSTERDAM, NL, vol. 403, 22 July 2020 (2020-07-22), XP086299375, ISSN: 1385-8947, [retrieved on 20200722], DOI: 10.1016/J.CEJ.2020.126352
- I.K. SONG: "The growth mode change in carbon nanotube synthesis in plasma-enhanced chemical vapor deposition", DIAMOND AND RELATED MATERIALS, vol. 13, no. 4-8, 1 April 2004 (2004-04-01), NL, pages 1210 - 1213, XP093163302, ISSN: 0925-9635, Retrieved from the Internet <URL:https://www.sciencedirect.com/science/article/pii/S092596350400010X/pdfft?md5=54af15cfa3baa192d4bb259c4f573ff2&pid=1-s2.0-S092596350400010X-main.pdf> DOI: 10.1016/j.diamond.2004.01.006
- KENNETH B K TEO: "Catalytic Synthesis of Carbon Nanotubes and Nanofibers", 1 January 2003 (2003-01-01), pages 1 - 22, XP093163282, Retrieved from the Internet <URL:http://nanotubes.rutgers.edu/PDFs/Catalytic%20Synthesis%20of%20Carbon%20Nanotubes%20and%20Nanofibers.pdf>

## Description

### FIELD OF INVENTION

A method for the manufacturing of metal sulphide/carbon nanotube-based hybrid nanostructures as binder-free electrodes, particularly for the electrochemical energy storage devices is provided.

### BACKGROUND OF THE INVENTION

Exhaustion of non-renewable energy sources and a large increase in the use of portable electronic devices requires energy storage devices to fulfil the energy needs beyond the consumer requirement. In particular, this concerns the portable electric devices, electric vehicles and other consumer electronics. Thus, high capacity electrochemical energy storage device is needed for addressing these problems. In this aspect, electrochemical supercapacitors and battery devices have prevailing importance because of their exceptional power density and charge storage properties.

A lithium-ion battery is one important type of rechargeable battery considered as a potential energy storage device for hybrid vehicles. High specific energy and power density, long cycle life, no memory effect and high-load capabilities are making them attractive to fulfil the energy needs beyond consumer electronics and electric vehicles. A battery is needed for providing a sufficient supply of power for the continuous working of electronic vehicles or gadgets. However, a battery will be limited if the device requires a rapid power supply, where a supercapacitor can be used for the rapid delivery of the required energy.

An electrochemical capacitor, also known as ultracapacitor or supercapacitor is a class of green energy storage device with higher capacitance value than other capacitors and have the feature of the lower voltage limits. A supercapacitor can store 10 to 100 times more energy per unit mass than the electrolytic capacitors and can deliver charge much faster than the batteries, with the fast charge-discharge process. Supercapacitors are mainly used for the devices which require a large number of charge-discharge cycles rather than the long-term compact energy storage. Typical examples can be found within hybrid vehicles and electronic devices. In a hybrid electric vehicle, a supercapacitor can supplement a battery to provide sufficient power for rapid acceleration and energy recuperation during braking.

Most of the currently available energy storage devices using carbon-based electrodes for the charge storage mechanism. However, commercially available carbon-based electrodes do not meet the requirement for the high energy density applications due to its low theoretical capacity. Alternatives to carbon-based materials are tin oxide, and silicon provides high energy density. However, some of the high capacity anodes have been found unsuitable due to the capacity fading and large volume expansions. The large volume expansion and structural changes can damage the electrode material and thereby decreasing the cycling stability.

Direct growth of active material on the conductive substrates (current collector) can allow the easy processing of the electrode, improve the electrical conductivity of the active material and can avoid the use of a polymeric binder. Trinickel disulphide (Ni₃S₂) based materials are a promising material for the electrochemical energy storage devices due to smaller volume change and high conversion reaction mechanism. However, owing to the poor conductivity of the sulphides, a conductive carbon matrix is beneficial to improve the conductivity of the electrode. Anchoring trinickel disulphide on a conductive carbon structure can be an alternative to overcome these issues.

US20200028203A1 reveals the application of metal sulphide composite materials for battery applications. The inventors have used a core-shell composite of Li₂S, metal oxide and conductive carbon as the electroactive material. An electrode material with a combination of iron metal, and lithium fluoride, lithium oxide, and/or lithium sulphide was illustrated in US20140272564A1. Guan et al. [1], Chandu et al. [2], Dai et al. [3], Wang et al. [4] explained different methods for the growth of Ni₃S₂ based materials on carbon backbone as an electrode material for energy storage devices. However, in all these cases, functional additives were used for the preparation of electrodes. This indicates the need for further processing to convert active material to the electrode.

A method for the preparation cobalt sulphide-nickel-carbon nanofiber composite material was given in CN105280896B. The inventors have used different methods, which include pre-oxidation high-temperature carbonisation technology, a hydrothermal method for preparing the electrodes. CN105895882B discloses a preparation method for nitrogen-doped graphene cladding nickel sulphide composite electrode materials. The invention was also comprised of high-temperature annealing for the preparation of electrode material. High-temperature synthesis conditions are not a suitable option for the large scale growth of electrode materials due to large energy consumption and critical treatment conditions.

The inventors are explaining a method for fabricating a carbon nanotube-metal sulfide composites in the innovation US20140034906A1. The inventors have used post-synthetic ultra-centrifugation purification techniques for the selective area functionalisation, and the metal sulfide compounds are deposited to the carbon nanotubes by atomic layer deposition techniques. The manufacturing, processing and compositing of the carbon nanotube-metal sulfide nanostructure involve multiple steps including purification and separation. CN105789624B and CN105895861B reveal the application of array type three Ni-based combination electrode for sodium-ion battery. The electrode was designated as Ni/Ni₃S₂/carbon nanotubes based structure. The inventors used a hydrothermal curing technique for the direct fabrication of electroactive material on a conductive substrate for the preparation of electrode material. However, electrode fabrication involves multiple chemical processing steps and a longer time period (more than 24 h).

Zhang et al. [5] explained a one-step synthesis of reduced graphene oxide/Ni₃S₂ based electrodes for high-performance supercapacitors, where the active materials were prepared by chemical methods. Chen et al. [6] demonstrated the preparation of sponge-like NiS/Ni₃S₂ hybrid nanosheets for supercapacitors using chemical treatment techniques. Tian et al. [7] explained a method for constructing Ni₃S₂ wrapped by reduced graphene oxide on carbon cloth for supercapacitor application. Zhang et al. [8], Zhu et al. [9], and Jiang et al. [10] explained different methods for the direct growth of having explored Ni₃S₂ based materials as an electrode for energy storage devices. In all these cases, preparation of the electrode material involves multiple processes, different chemicals and longer time period (more than 24 h). Among all these methods, Ni₃S₂ based metal sulphides combined with a conductive carbon structure used as an electrode for energy storage devices provided higher capacity, better stability and higher energy density compared to plain carbon-based electrodes. However, an alternative technique that can fasten the electrode preparation can overcome the issues related to the longer electrode preparation procedure. An electrode material with intimate contact with the current collector and with large surface area that can participate in electrochemical reaction can significantly improve the energy storage performance. Direct growth of hierarchical carbon nanostructures as conductive channel, which are then composed with high specific energy material will solve the issue related to the stability and performance of the energy storage device.

Plasma-enhanced chemical vapour deposition can be used as an alternative technique for the direct growth of conductive carbon nanostructures, which also enables to control the orientation of carbon material. EP1190987A1 reveals the synthesis of carbon nanotubes in the presence of a catalyst material heated by a heating method such as microwave irradiation, electromagnetic inductive heating, radio frequency heating or laser heating. JP4536456B2 reveals the growth of carbon nanotubes, which are grown as in the form of rising from the substrate surface. Carbon nanostructures with catalyst nanoparticle on the backbone can be potentially tuned to make hybrid composites. WO2002088024A1 provides a method for synthesising nanotubes coated with metal sulphide, selenide or telluride. The processes in the aforementioned patents involve multiple steps and high-temperature treatments. Mohamadalizadeh et al.[11] explained a procedure for the sulphur decorated carbon nanotubes using hydrogen sulphide oxidation at the low-temperature reaction. However, in both process, there is no control over the anchoring of sulphur on the carbon nanotube backbone.

CN110033959A discloses an energy storage device with high capacity electrochemically active materials including a nickel sulfide-doped 3D carbon nanotube foam composite material. The nickel sulfide-doped 3D carbon nanotube is synthesised by using a nickel-doped 3D carbon nanotube net as a substrate and using a hydrothermal reaction to synthesise the foam composite material. US2013/074771A1 discloses a tip growth mechanism for growing carbon nanotubes on a substrate with catalyst particles thereon, resulting in a catalyst particle at the tip of each CNT. The process includes a first step wherein a layer of catalyst material is deposited on a substrate. US2014/349216A1 discloses a process wherein CNTs are produced on a metal oxide layer on a metal substrate and not directly on the metal substrate. Only base-growth is disclosed as the seed crystal is embedded in in the buried end of the CNT. CN109872881A discloses an application of a nickel sulfide/carbon nanotube flexible composite thin film material on a supercapacitor. The CNTs are produced do not point in a direction perpendicular to the surface of the conductive metal substrate, but rather form a random 'carbon nanotube network' having a 3D porous structure.

US2004/241532A1 discloses an electrode made of carbon nanotubes. The sulfur or metal nanoparticles are bonded, deposited or fused on the surfaces of the CNTs so that the CNTs are bonded to each other and also bonded to the current collector. US2011/204020A1 discloses multilayer carbon nanotube capacitators. The capacitators are formed by depositing a plurality of carbon nanotube-magnetic catalyst. RU2660819C1 discloses a method for manufacturing supercapacitor electrodes. The method comprises applying a buffer layer, a catalytic bed, a dielectric layer, an insulating layer in the dielectric layer of the window matrix to a catalytic bed, deposition in the windows of arrays of vertically oriented carbon nanotubes, the functionalization of the surface of carbon nanotubes by oxygen-containing groups, the layer formation of polyaniline containing the isotope C-14, on vertically oriented carbon nanotubes by electrochemical deposition, and lastly annealing. Jeon et al. [12] disclose Ni₃Si₂/Ni structures synthesised on the surface of the 3D carbon fiber webs (CFWs) using electroless plating of Ni and subsequent sulfuration. Milne et al.[13] discloses carbon nanotube and nanofiber growth by catalytic CVD method. The addition of trace amounts of thiophene (sulfur containing compound) to liquid hydrocarbons is reported to promote the growth of single wall carbon nanotubes.

In this aspect, the direct growth of carbon nanostructures by plasma-enhanced techniques, preferably vertically aligned carbon nanotubes (CNT) on a conductive substrate can be a promising structure for anchoring sulphur. Presence of metallic nanoparticles on the carbon backbone enables the controlled transformation of the metallic nanoparticle to metal sulphide compounds. The vertical alignment of these composite structures is specifically designed for the maximum available surface area of active material to interact with the electrolyte solution. As an example, CNT deposited on nickel substrate contains nickel nanoparticle, which upon sulphur anchoring gets converted to nickel sulphide compounds. Therefore, this, nickel sulphide/vertically aligned CNT based hybrid hierarchical structure could be a potential composite material for excellent electrochemical energy storage performance.

### SUMMARY OF THE INVENTION

The present invention addresses a fast two-step method for the preparation of hybrid binder-free electrodes for electrochemical energy storage devices. In the present invention, a method is provided for manufacturing metal sulphide-carbon nanostructure based hybrid binder-free electrode for electrochemical energy storage devices. The electrode material prepared by this invention comprises of a metal sulphide anchored on a conductive vertically oriented carbon matrix on a conductive substrate made of the same metal as the sulphide.

The scope of the present invention is defined by the appended set of claims. Hence, in a first aspect, the present invention provides a method for manufacturing a hybrid binder-free electrode for electrochemical energy storage devices, said hybrid binder-free electrode comprising, preferably consisting of, a conductive metal substrate and carbon nanotubes attached to the conductive metal substrate, wherein each carbon nanotube has only one single-crystal metal nanoparticle positioned at its tip with a metal sulphide top layer, the method comprising the following subsequent steps:
a) growing carbon nanotubes, preferably multi-walled carbon nanotubes, in a processing chamber (21) using a tip-growth mechanism, wherein each carbon nanotube has only one single-crystal metal nanoparticle positioned at its tip, on a conductive metal substrate in a direction perpendicular to the surface of the conductive metal substrate, wherein the metal of the single-crystal metal nanoparticles and the metal of the conductive metal substrate are the same;
b) providing the carbon nanotubes grown on the conductive metal substrate (12) as obtained in step (a) in another processing chamber (11) and evacuating said processing chamber (11) to a pressure below 100 Pa, preferably to a pressure below 1 Pa, using a vacuum pump (16) and a pressure gauge (15);
c) supplying sulphur-containing gas (13) to the evacuated processing chamber (11) of step (b) to obtain a partial pressure of the sulphur-containing gas of between 1 Pa and 1.105 Pa;
d) setting the temperature inside the processing chamber (11) to between 25 and 300 °C, preferably to between 100 and 150 °C, with a heating element (14);
e) allowing the single-crystal metal nanoparticles at the tips of the carbon nanotubes to interact with the sulphur-containing gas (13) inside the processing chamber (11), leading to the formation of a metal sulphide top layer on the single-crystal metal nanoparticles; and
f) assuring that the temperature of the processing chamber (11) drops below a threshold value, preferably below 35 °C, and subsequently venting the processing chamber (11) to atmospheric pressure,
wherein no binder is applied during the process.

In this invention, we have used metal foils with catalytic properties as the conductive substrate (e.g. nickel, copper, cobalt). The composition of electrode material comprises of metal sulphide anchored on carbon backbone, which is deposited on the said metal foil. The carbon backbone, which is vertically oriented on the metal foil, comprises of multi-walled carbon nanotubes with a diameter of 50-100 nm and faceted with a metallic nanoparticle at its top. The said vertically aligned carbon nanotubes are fabricated by a low-pressure plasma deposition system in a methane atmosphere. Later, the said vertically aligned carbon nanotubes deposited on conductive substrate is thermally treated in a sulphur-containing atmosphere for the fabrication of metal sulphide-carbon nanotube-based composite material. The metal sulphide preferably comprises of a polycrystalline structure. The said composite material is directly grown on the conductive substrate, and use of this material as a binder-free electrode for energy storage devices will address the challenges related to the electrode fabrication. As an example, we have fabricated composite material on a nickel substrate in the form of upstanding trinickel disulphide-nickel-carbon nanotube structure and used as a negative electrode for lithium-ion batteries. The negative electrode prepared by the example presented in the invention delivered a reversible capacity above 1000 mAh g⁻¹ after 100 cycles at a current density of 100 mA g⁻¹. Moreover, the negative electrode possesses long-term stability by maintaining a reversible capacity above 750 mAh g⁻¹ after 500 cycles at a current density of 200 mA g⁻¹. As an electrode for supercapacitor device, the electrode prepared by the present invention during a charge-discharge cycling at a current density of 2 A·g⁻¹ said electrode after many cycles (more than 2000) delivers a specific capacity of more than 400 C·g⁻¹, and wherein the specific capacity retains above 80 % of the initial specific capacity (more than 300 C·g⁻¹) at higher current densities (more than 10 A·g⁻¹)..

In another aspect of the invention, there is provided a hybrid binder-free electrode for electrochemical energy storage devices obtained by the method of the invention, said hybrid binder-free electrode comprising, preferably consisting of, a conductive metal substrate with carbon nanotubes having an average length of preferably 1 to 2 µm and an average diameter of preferably 50 to 100 nm attached thereto, wherein each carbon nanotube has only one single-crystal metal nanoparticle positioned at its tip with a metal sulphide layer on top of the single-crystal metal nanoparticle, wherein the carbon nanotubes point in a direction perpendicular to the surface of the conductive metal substrate, wherein the metal of the single-crystal metal nanoparticles, the metal of the metal sulphide layer and the metal of the conductive metal substrate are the same, and wherein the metal sulphide layer on top of the single-crystal metal nanoparticle is preferably in the form of polycrystalline nanostructures, more preferably in the form of polycrystalline nanostructures with individual crystallite sizes of between 20 and 50 nm.

In another aspect of the disclosure, not part of the claims, there is provided a hybrid binder-free electrode for electrochemical energy storage devices, said hybrid binder-free electrode comprising, preferably consisting of, a conductive metal substrate with carbon nanotubes having an average length of preferably 1 to 2 µm and an average diameter of preferably 50 to 100 nm attached thereto, wherein each carbon nanotube has only one single-crystal metal nanoparticle positioned at its tip with a metal sulphide layer on top of the single-crystal metal nanoparticle, wherein the carbon nanotubes point in a direction perpendicular to the surface of the conductive metal substrate, wherein the metal of the single-crystal metal nanoparticles, the metal of the metal sulphide layer and the metal of the conductive metal substrate are the same, and wherein the metal sulphide layer on top of the single-crystal metal nanoparticle is preferably in the form of polycrystalline nanostructures, more preferably in the form of polycrystalline nanostructures with individual crystallite sizes of between 20 and 50 nm.

In another aspect of the disclosure, there is provided the use of hybrid binder-free electrode obtained according to the method of the invention:
- as or in a negative electrode for lithium-ion batteries, wherein said negative electrode preferably delivers a reversible capacity above 1000 mA·h·g 1 after 100 cycles at a current density of 100 mA-g 1, and wherein the negative electrode preferably possesses long-term stability by maintaining a reversible capacity above 750 mA·h·g 1 after 500 cycles at a current density of 200 mA·g 1; or
- as or in an electrode for a supercapacitor, wherein during a charge discharge cycling at a current density of 2 A·g-1 said electrode after many cycles (more than 2000) preferably delivers a specific capacity of more than 400 C·g-1, and wherein the specific capacity retains above 80 % of the initial specific capacity (more than 300 C·g-1) at higher current densities (more than 10 A·g 1).

Compared with the prior art, the present invention has the following advantages:
- The vertically oriented carbon nanotube and trinickel disulphide hybrid composite nanostructure is directly grown on a conductive substrate and used directly as electrode without adding any additive agents (as in US20140272564A1, US20200028203A1).
- The trinickel disulphide is grown only at the tip of the carbon nanotube, where the metallic nickel nanoparticle at the tip of the carbon nanotube transformed to trinickel disulphide in a controlled manner. Vertical carbon nanotubes act as the intimate conductive channel between the current collector and trinickel disulphide and improve the diffusion-reaction during an electrochemical reaction.
- The electrode fabrication is done by a fast (less than 6 h) two-step procedure.
- Polycrystalline phase and intimate contact of trinickel disulphide to the current collector through carbon nanotubes improves the conversion reaction during an electrochemical process and enhances the capacity and stability of the material as an electrode for the energy storage devices.

### BRIEF DESCRIPTION OF THE DRAWINGS

Figure 1 presents a schematic of the processing chamber for the deposition of vertically aligned carbon nanostructure with the position of the conductive substrate.
Figure 2 presents a schematic of the processing chamber for the growth metal sulphide on vertically carbon nanostructures.
Figure 3 (a)shows the SEM image of the as-deposited carbon nanostructure on the nickel foil and the vertical orientation. Figure 3 (b)shows the SEM micrograph of the vertically aligned carbon/nickel sulphide hybrid nanostructure.
Figure 4 (a) represents the TEM micrograph of the carbon nanotubes faceted with metallic Ni nanoparticle directly deposited on Ni foil. Figure 4 (b) exhibits the TEM micrograph of the controlled transformation of faceted nickel to nickel sulphide and forming a hybrid Ni₃S₂/Ni/VCN nanostructure.
Figure 5 exhibits the experimental SAED pattern for nickel sulphide, Ni and carbon, for identifying the crystal phases and corresponding simulated patterns for identified nickel sulphide phase of Ni₃S₂, Ni, and carbon (C).

### DETAILED DESCRIPTION OF THE INVENTION

The present invention may be understood more readily in accordance with the following detailed description of the invention taken in connection with associated figures. It is to be understood that the present invention is not limited to specific methods, conditions, devices, or parameters that are described herein. The expressions used in this present invention is for particular embodiments by way of example and is not intended to be limiting of the claimed invention.

The expression "VCN" shall be understood as vertically aligned carbon nanotube to define the orientation of deposited carbon is perpendicular to the conductive metal substrate. The expression "carbon structures with faceted metallic nanoparticle" shall be understood to define the vertical carbon nanostructures terminated with a single crystal metallic nanoparticle. The expression sccm shall be understood as a standard cubic centimetre per minute. It is a volumetric measure unit of flow defined at standard conditions: temperature of 273,15 K and pressure of 100000 Pa. The expression "binder-free electrode" shall be understood as any polymeric binder is not used during the electrode fabrication.

To define the geometry and dimension of VCN, the VCN is described as having a length (largest dimension) and a diameter (smallest dimension). The length of VCN produced by the method of the invention is higher than 1 µm, and the diameter is not greater than 100 nm. To define the geometry of the metallic nanoparticle, the nanoparticle is described as having a thickness, which is no greater than 100 nm. The geometry of metal sulphide located on VCN produced by the method of the invention is described as having polycrystalline phases, where the size of individual crystallite is not greater than 50 nm.

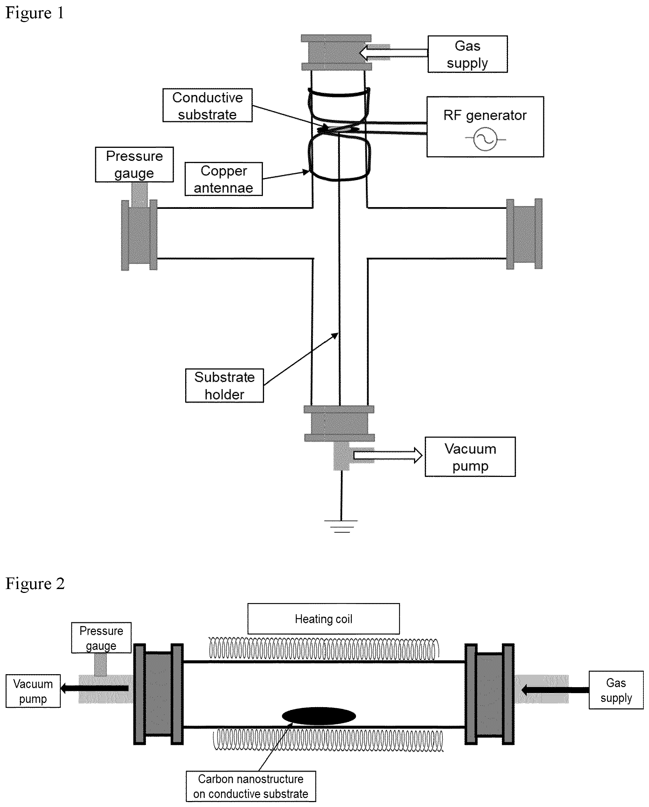

A preferential fabrication of carbon nanostructure used for the preferred embodiment of the present invention is the vapour deposition process, preferably a plasma deposition system. Schematic for the experimental setup of a plasma vapour deposition system shown in Figure 1. The plasma system consists of a dielectric chamber, preferably borosilicate glass with a preferable geometry of cross-type glass tube. The chamber is coupled to a high-frequency plasma generator, preferably 13.56 MHz radio-frequency plasma generator (rf) through a copper antenna. A conductive metal foil (e.g. nickel, copper, cobalt) is used as the substrate for the deposition. The thickness of the said metal foil is greater than 1 µm, preferably 25 µm. The substrate is placed on a conductive substrate holder, which is electrically grounded during the process. The chamber is evacuated to low pressure below 10 Pa using a rotary vacuum pump. The pressure inside the chamber is measured using any low-pressure pressure gauge. Carbon-containing gas is supplied to the processing chamber for the deposition process, and it is fed through a mass flow controller at a flow rate not less than 1 sccm. The plasma is ignited at power not higher than 1000 W for the deposition of carbon nanostructures. The plasma deposition process has done for a time period of not less than 1 min. The processing chamber and substrate holder is not supported by any external heating stage during the deposition process. The substrate is heated due to the plasma heating effects during the deposition itself. The said substrate is taken out after the plasma deposition and after the temperature of the substrate holder drop below a threshold value, preferably below 35°C. The resulting product is a metal foil with vertically oriented carbon nanotubes. The nanotubes are multi-walled with diameters between 50 and 100 nm and an average height between 1-2 µm. Their upstanding tips are faceted by crystal nanoparticle from the same metal as the substrate.

A preferred example of the present invention is a method for the synthesis of metal sulphide-carbon nanostructure composite material. The material is fabricated in the presence of sulphur-containing gas by a thermal annealing method in a processing chamber. The said chamber is a long cylindrical quartz tube attached to a furnace system. The said carbon nanostructures deposited on a conductive metal substrate, which can be produced by a method described in this disclosure or other method are placed in the said processing chamber. Best results in terms of uniformity of the compound are obtained when only one gas is used. Therefore, the processing chamber is evacuated to a pressure below 100 Pa, preferably below 1 Pa using a vacuum pump and a pressure gauge. In the next step, the said processing chamber heated to a temperature between 25 °C and 300 °C, preferably between 100-150 °C. Later, sulphur-containing gas is leaked into the processing chamber. The pressure exerted by the sulphur-containing gas is between 1 Pa and 1*10⁵ Pa, preferably 8*10⁴-9*10⁴ Pa. The said carbon nanostructures on a conductive substrate and metal nanoparticle top are kept inside the processing chamber at said conditions for a time period between 30 min and 240 min, preferably 150-200 min. The said processing chamber evacuated to atmospheric pressure after the processing time to remove the excess sulphur-containing gas in the chamber. Later the metal sulphide-carbon nanostructures deposited on the conductive substrate has taken out, preferably after the temperature of the processing chamber reaches below a pain threshold, preferably 35°C. The schematic of the said processing chamber is presented in Figure 2. The said product is directly grown on the conductive substrate and can directly use as a binder-free electrode for energy storage devices.

The following example serves to demonstrate the preferred embodiments of the present invention and should not be interpreted as limiting the scope of the invention:

### EXAMPLE 1

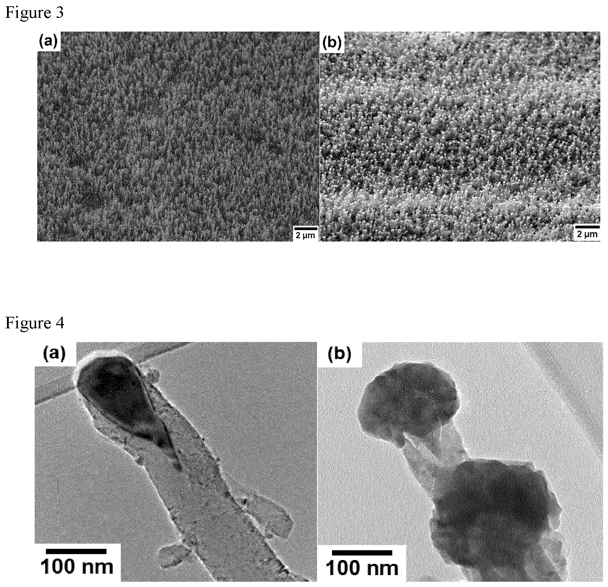

Method of inventions has been applied to prepare a metal sulphide-carbon nanostructure-based binder-free electrode. In this example, metallic nickel foil with a thickness of 25 µm and a diameter of 14 mm is used as the conductive substrate. As the first step, carbon nanostructure was deposited on the nickel foil using plasma-assisted deposition system. The nickel foil was placed on the substrate holder inside the plasma processing chamber in the middle of the coil (Figure 1). The sample holder was electrically grounded during the deposition. Then the processing chamber - borosilicate glass tube - was evacuated with a rotary vacuum pump to a low-pressure below 10 Pa. Then methane gas was leaked into the processing chamber as the carbon precursor at the flow rate of 20 sccm. The pressure inside the processing chamber was 30 Pa. After establishing the atmosphere for carbon deposition, the RF generator was turned on at a power 800 W. After 4 min the RF generator and methane supply was turned off. The temperature of the sample holder reaches 700-800 °C during the deposition process due to the plasma heating effects. After an additional 6 min, the temperature of the sample holder was cooled to a temperature below the threshold pain. The processing chamber was vent and opened to take out the sample. To observe the morphology of the deposited carbon nanostructure, SEM analysis was performed. Figure 3 (a) presents the SEM micrograph of the surface morphology of the as-deposited carbon nanostructure, in particular the vertically aligned tube-like structure with a faceted nickel nanoparticle on top directly grown on the conductive nickel substrate.

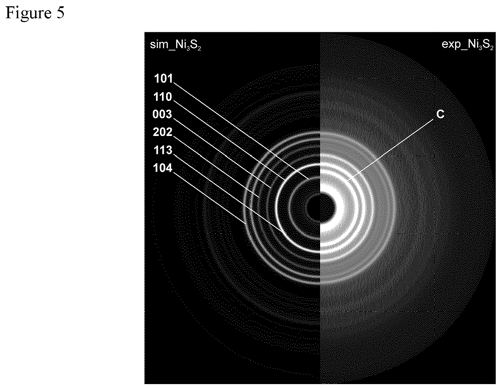

In the next step, the nickel foil with the deposited carbon nanostructure was placed in a thermal treatment chamber for the growth of metal sulphide. The processing chamber was evacuated to a low-pressure below 1 Pa. Then hydrogen sulphide (H₂S) gas was leaked into the processing chamber as the sulphur-containing gas and the pressure inside the chamber was kept as 9*10⁴ Pa. The temperature of the chamber was elevated to 125 °C with a rate of 6 °C/min using a furnace, and annealed for 180 min. Afterwards, the furnace was let to cool down to room temperature, and the H₂S gas was pumped out. During this step, the sulphides have successfully formed from the nickel nanostructures without destroying the underlying carbon nanostructures. Figure 3 (b) shows the SEM micrograph of the composite material containing metal and carbon nanostructure, in particular VCN and nickel sulphide. Both nanostructures are vertically aligned on the substrate surface with an average height between 1-2 µm and uniformly covering the substrate surface. Figure 4 (a) presents the TEM micrograph of the individual tube-like structure of carbon nanostructure with an average diameter of 50-100 nm with a faceted metallic Ni nanoparticle at the tip. No other nanoparticles are observed on the backbone of the VCN structure due to the fact that VCN is grown by a tip-growth mechanism. Figure 4 (b) shows the TEM micrograph of the composite material containing metal and carbon nanostructure, in particular VCN and nickel sulphide. The sulphur is only attached to the faceted Ni nanoparticle with an average size of 50-100 nm. The composite material is comprised of nickel sulphide with a nickel core and VCN backbone. There are no other sulphur nanoparticles observed on the backbone of the VCN due to the fact that sulphur is only attached to the Ni nanoparticles. The nickel sulphide is formed in the form of polycrystalline with an average individual crystallite size of 20-50 nm. To identify the phase of nickel sulphide selected area diffraction (SAED) pattern of the composite was analysed. Figure 5 represents the experimental corresponding simulated patterns of SAED. SAED is corresponding to the Ni₃S₂ (heazlewoodite) crystal structure and also to the Ni and carbon, which is due to the presence of Ni core and VCN backbone. The obtained composite product is confirmed as Ni₃S₂/Ni/VCN hybrid hierarchical structure.

The use of said composite nanostructure as a binder-free electrode for electrochemical energy devices can allow the easy processing of electrode, improve the electrical conductivity of the active material and can avoid the use of a polymeric binder. As a negative electrode for lithium-ion batteries said, electrode delivered a reversible capacity above 1000 mAh g⁻¹ after 100 cycles at a current density of 100 mA g⁻¹ and possessed long-term stability by maintaining a reversible capacity above 750 mAh g⁻¹ after 500 cycles at a current density of 200 mA g⁻¹. As an electrode for supercapacitor, the said electrode delivered a specific capacitance about 4 times higher than initial value and retained above 80 % of the initial capacity at higher current densities (>10 A g⁻¹).

### References Relating To

1. Guan, X.; Liu, X.; Xu, B.; Liu, X.; Kong, Z.; Song, M.; Fu, A.; Li, Y.; Guo, P.; Li, H. Carbon wrapped Ni3S2 nanocrystals anchored on graphene sheets as anode materials for Lithium-Ion battery and the study on their capacity evolution. Nanomaterials 2018, doi:10.3390/nano8100760.
2. Muralee Gopi, C. V. V.; Ravi, S.; Rao, S. S.; Eswar Reddy, A.; Kim, H. J. Carbon nanotube/metal-sulfide composite flexible electrodes for high-performance quantum dot-sensitised solar cells and supercapacitors. Sci. Rep. 2017, 7, 1-12, doi: 10.1 038/srep465 19.
3. Dai, C. S.; Chien, P. Y.; Lin, J. Y.; Chou, S. W.; Wu, W. K.; Li, P. H.; Wu, K. Y.; Lin, T. W. Hierarchically structured Ni3S2/carbon nanotube composites as high performance cathode materials for asymmetric supercapacitors. ACS Appl. Mater. Interfaces 2013, 5, 12168-12174, doi:10.1021/am404196s.
4. Wang, C.; Han, Q.; Xie, R.; Wang, B.; He, T.; Xie, W.; Tang, Q.; Li, Y.; Xu, J.; Yu, B. Fabrication of petal-like Ni3S2 nanosheets on 3D carbon nanotube foams as high-performance anode materials for Li-ion batteries. Electrochim. Acta 2020, 331, doi:10.1016/j.electacta.2019.135383.
5. Zhang, Z.; Zhao, C.; Min, S.; Qian, X. A facile one-step route to RGO/Ni3S2for high-performance supercapacitors. Electrochim. Acta 2014, 144, 100-110, doi:10.1016/j.electacta.2014.08.03 8.
6. Chen, F.; Wang, H.; Ji, S.; Linkov, V.; Wang, R. High-performance all-solid-state asymmetric supercapacitors based on sponge-like NiS/Ni3S2 hybrid nanosheets. Mater. Today Energy 2019, 11, 211-217, doi:10.1016/j.mtener.2018.12.002.
7. Tian, Z.; Yin, J.; Wang, X.; Wang, Y. Construction of Ni3S2 wrapped by rGO on carbon cloth for flexible supercapacitor application. J. Alloys Compd. 2019.
8. Zhang, R.; Li, X.; Zhu, Y.; Shen, Y.; Xie, A. Ni3S2@Graphene oxide nanosheet arrays grown on NF as binder-free anodes for lithium ion batteries. J. Alloys Compd. 2019, doi:10.1016/j.jallcom.2019.151861.
9. Zhu, J.; Hu, G. Facile synthesis of three-dimensional porous Ni3S2 electrode with superior lithium ion storage. Mater. Lett. 2016, doi:10.1016/j.matlet.2015.12.109.
10. Jiang, J.; Ma, C.; Yang, Y.; Ding, J.; Ji, H.; Shi, S.; Yang, G. Synergetic interface between NiO/Ni 3 S 2 nanosheets and carbon nanofiber as binder-free anode for highly reversible lithium storage. Appl. Surf. Sci. 2018, 441, 232-238, doi:10.1016/j.apsusc.2018.02.053.
11. Mohamadalizadeh, A.; Towfighi, J.; Adinehnia, M.; Bozorgzadeh, H. R. H2S oxidation by multi-wall carbon nanotubes decorated with tungsten sulfide. Korean J. Chem. Eng. 2013, 30, 871-877, doi:10.1007/s11814-012-0190-1.
12. Choi, B. G.; Lee, D. K.; Jeon H. High-performace pseudocapacitator electrodes based on the flower-like nickel sulfide coated carbon nanofiber webs. Microelectronic Engineering. 2020, 222, 1-20, doi:10.1016/J.MEE.2019.111205.
13. Teo B.K., Singh C.; Chhowalla M., Milne W.; Catalytic Synthesis of Carbon Nanotubes and Nanofibers, University of Cambridge, 2003, 1-22, URL: http://nanotubes.rutgers.edu/PDFs/Catalytic%20Synthesis%20of%20Carbon%20Na notubes%20and%20Nanofibers.pdf.

## Claims

1. A method for manufacturing a hybrid binder-free electrode for electrochemical energy storage devices, said hybrid binder-free electrode comprising, preferably consisting of, a conductive metal substrate and carbon nanotubes attached to the conductive metal substrate, wherein each carbon nanotube has only one single-crystal metal nanoparticle positioned at its tip with a metal sulphide top layer, the method comprising the following subsequent steps:
a) growing carbon nanotubes, preferably multi-walled carbon nanotubes, in a processing chamber (21) using a tip-growth mechanism, wherein each carbon nanotube has only one single-crystal metal nanoparticle positioned at its tip, on a conductive metal substrate in a direction perpendicular to the surface of the conductive metal substrate, wherein the metal of the single-crystal metal nanoparticles and the metal of the conductive metal substrate are the same;
b) providing the carbon nanotubes grown on the conductive metal substrate (12) as obtained in step (a) in another processing chamber (11) and evacuating said processing chamber (11) to a pressure below 100 Pa, preferably to a pressure below 1 Pa, using a vacuum pump (16) and a pressure gauge (15);
c) supplying sulphur-containing gas (13) to the evacuated processing chamber (11) of step (b) to obtain a partial pressure of the sulphur-containing gas of between 1 Pa and 1·10⁵ Pa;
d) setting the temperature inside the processing chamber (11) to between 25 and 300 °C, preferably to between 100 and 150 °C, with a heating element (14);
e) allowing the single-crystal metal nanoparticles at the tips of the carbon nanotubes to interact with the sulphur-containing gas (13) inside the processing chamber (11), leading to the formation of a metal sulphide top layer on the single-crystal metal nanoparticles; and
f) assuring that the temperature of the processing chamber (11) drops below a threshold value, preferably below 35 °C, and subsequently venting the processing chamber (11) to atmospheric pressure,
wherein no binder is applied during the process.

2. Method according to claim 1, wherein the metal sulphide top layer on the single-crystal metal nanoparticles is in the form of polycrystalline nanostructures, more preferably in the form of polycrystalline nanostructures with individual crystallite sizes of between 20 and 50 nm.

3. Method according to claim 1 or 2, wherein the metal of the conductive metal substrate is catalytic towards carbon nanotube synthesis, wherein the metal of the conductive metal substrate is preferably chosen from the group consisting of nickel, cobalt and copper.

4. Method according to any one of claims 1 to 3, wherein the metal of the conductive metal substrate is nickel and wherein the metal sulphide is trinickel disulphide (Ni₃S₂).

5. Method according to any one of claims 1 to 4, wherein the carbon nanotubes have an average diameter of between 50 and 100 nm and an average length of between 1 and 2 µm.

6. Method according to any one of claims 1-5, wherein the sulphur-containing gas (13) applied in step (c) is hydrogen sulphide (H₂S) and wherein the partial pressure of the sulphur-containing gas is between 8·10⁴ and 9·10⁴ Pa.

7. Method according to any one of claims 1-6, wherein the interaction time in step (e) is between 30 and 240 min., preferably between 150 and 200 min.

8. Method according to any one of claims 1-7, wherein the carbon nanotubes are grown in step (a) using a plasma vapour deposition tip-growth method comprising the following steps:
i) arranging the conductive metal substrate (25) on a grounded conductive substrate holder (22) in the processing chamber (21);
ii) evacuating the processing chamber (21) to obtain a pressure below 10 Pa;
iii) supplying a carbon-containing gas (26) into the processing chamber to obtain a partial pressure of the carbon-containing gas inside the processing chamber (21) of between 10 Pa and 1000 Pa;
iv) creating a plasma inside the processing chamber using a high-frequency plasma generator (23);
v) allowing the plasma inside the processing chamber (21) to interact with the conductive metal substrate (25) to allow growth of the carbon nanotubes on the conductive metal substrate in a direction perpendicular to the surface of the conductive metal substrate, wherein each carbon nanotube has only one single-crystal metal nanoparticle positioned at its tip;
vi) turning off the high-frequency plasma generator (23);
vii) assuring the temperature of the conductive substrate holder (22) to drop below a threshold value, preferably below 35°C; and
viii) venting the processing chamber (21) to atmospheric pressure.

9. Method according to claim 8, wherein the high-frequency plasma generator (23), preferably a radio-frequency (RF) plasma generator, applied in step (iv) is coupled, preferably using inductive coupling, to a conductive metal coil (24), preferably a copper coil, wrapped around the processing chamber (21).

10. Method according to claim 8 or 9, wherein the growth of the carbon nanotubes in step (v) is performed continuously for a duration of between 1 and 30 min, preferably about 4 min.

11. Method according to any one of claims 8 - 10, wherein the carbon-containing gas (26) applied in step (iii) is selected from the group consisting of methane, carbon dioxide, ethylene, and acetylene, wherein the carbon-containing gas (26) preferably is methane, more preferably methane with a purity greater than 99 % wherein the partial pressure of the methane inside the processing chamber (21) is between 20 and 60 Pa after the methane supply.

12. Method according to any one of claims 8 - 11, wherein the plasma inside the processing chamber (21) is created at high power, preferably between 500-1000 W.

13. A hybrid binder-free electrode for electrochemical energy storage devices obtained by the method of any one of claims 1 - 12, said hybrid binder-free electrode comprising, preferably consisting of, a conductive metal substrate with carbon nanotubes having an average length of preferably 1 to 2 µm and an average diameter of preferably 50 to 100 nm attached thereto, wherein each carbon nanotube has only one single-crystal metal nanoparticle positioned at its tip with a metal sulphide layer on top of the single-crystal metal nanoparticle,
wherein the carbon nanotubes point in a direction perpendicular to the surface of the conductive metal substrate,
wherein the metal of the single-crystal metal nanoparticles, the metal of the metal sulphide layer and the metal of the conductive metal substrate are the same, and
wherein the metal sulphide layer on top of the single-crystal metal nanoparticle is preferably in the form of polycrystalline nanostructures, more preferably in the form of polycrystalline nanostructures with individual crystallite sizes of between 20 and 50 nm.

14. Hybrid binder-free electrode according to claim 13, wherein the metal is nickel and wherein the metal sulphide is trinickel disulphide (Ni₃S₂).

15. Use of the hybrid binder-free electrode according to claim 13 or 14:
• as or in a negative electrode for lithium-ion batteries, wherein said negative electrode preferably delivers a reversible capacity above 1000 mA·h·g⁻¹ after 100 cycles at a current density of 100 mA·g⁻¹, and wherein the negative electrode preferably possesses long-term stability by maintaining a reversible capacity above 750 mA·h·g⁻¹ after 500 cycles at a current density of 200 mA·g⁻¹; or
• as or in an electrode for a supercapacitor, wherein during a charge-discharge cycling at a current density of 2 A·g⁻¹ said electrode after many cycles (more than 2000) preferably delivers a specific capacity of more than 400 C·g⁻¹, and wherein the specific capacity retains above 80 % of the initial specific capacity (more than 300 C·g⁻¹) at higher current densities (more than 10 A·g⁻¹).

## Patentansprüche

1. Verfahren zum Herstellen einer hybriden bindemittelfreien Elektrode für elektrochemische Energiespeichervorrichtungen, wobei die besagte hybride bindemittelfreie Elektrode ein leitfähiges Metallsubstrat und an dem leitfähigen Metallsubstrat befestigte Kohlenstoffnanoröhren umfasst, vorzugsweise daraus besteht, wobei jede Kohlenstoffnanoröhre nur ein an ihrer Spitze angeordnetes einkristallines Metallnanopartikel mit einer Metallsulfid-Deckschicht aufweist, wobei das Verfahren die folgenden nachfolgenden Schritte umfasst:
a) Züchten von Kohlenstoffnanoröhren, vorzugsweise mehrwandigen Kohlenstoffnanoröhren, in einer Verarbeitungskammer (21) unter Verwendung eines Spitzenwachstumsmechanismus, wobei jede Kohlenstoffnanoröhre nur ein an ihrer Spitze angeordnetes einkristallines Metallnanopartikel auf einem leitfähigen Metallsubstrat in einer Richtung senkrecht zu der Oberfläche des leitfähigen Metallsubstrats aufweist, wobei das Metall der einkristallinen Metallnanopartikel und das Metall des leitfähigen Metallsubstrats dasselbe sind;
b) Bereitstellen der auf dem leitfähigen Metallsubstrat (12) gezüchteten Kohlenstoffnanoröhren, wie in Schritt (a) erhalten, in einer anderen Verarbeitungskammer (11) und Evakuieren der besagten Verarbeitungskammer (11) auf einen Druck unter 100 Pa, vorzugsweise auf einen Druck unter 1 Pa, unter Verwendung einer Vakuumpumpe (16) und eines Druckmessers (15);
c) Zuführen von schwefelhaltigem Gas (13) zu der evakuierten Verarbeitungskammer (11) aus Schritt (b), um einen Partialdruck des schwefelhaltigen Gases zwischen 1 Pa und 1•10⁵ Pa zu erhalten;
d) Einstellen der Temperatur innerhalb der Verarbeitungskammer (11) auf 25 bis 300 °C, vorzugsweise auf 100 bis 150 °C, mit einem Heizelement (14);
e) Ermöglichen der Wechselwirkung der einkristallinen Metallnanopartikel an den Spitzen der Kohlenstoffnanoröhren mit dem schwefelhaltigen Gas (13) innerhalb der Verarbeitungskammer (11), was zu der Bildung einer Metallsulfid-Deckschicht auf den einkristallinen Metallnanopartikeln führt; und
f) Sicherstellen, dass die Temperatur der Verarbeitungskammer (11) unter einen Schwellenwert, vorzugsweise unter 35 °C, fällt und anschließendes Entlüften der Verarbeitungskammer (11) auf Atmosphärendruck,
wobei während des Verfahrens kein Bindemittel angewendet wird.

2. Verfahren nach Anspruch 1, wobei die Metallsulfid-Deckschicht auf den einkristallinen Metallnanopartikeln in Form von polykristallinen Nanostrukturen vorliegt, besonders bevorzugt in Form von polykristallinen Nanostrukturen mit individueller Kristallitgröße zwischen 20 und 50 nm.

3. Verfahren nach Anspruch 1 oder 2, wobei das Metall des leitfähigen Metallsubstrats katalytisch auf die Kohlenstoffnanoröhren-Synthese wirkt, wobei das Metall des leitfähigen Metallsubstrats vorzugsweise aus der Gruppe ausgewählt ist, die aus Nickel, Kobalt und Kupfer besteht.

4. Verfahren nach einem der Ansprüche 1 bis 3, wobei das Metall des leitfähigen Metallsubstrats Nickel ist und wobei das Metallsulfid Trinickeldisulfid (Ni₃S₂) ist.

5. Verfahren nach einem der Ansprüche 1 bis 4, wobei die Kohlenstoffnanoröhren einen durchschnittlichen Durchmesser von 50 bis 100 nm und eine durchschnittliche Länge von 1 bis 2 µm aufweisen.

6. Verfahren nach einem der Ansprüche 1 - 5, wobei das in Schritt (c) angewendete schwefelhaltige Gas (13) Schwefelwasserstoff (H₂S) ist und wobei der Partialdruck des schwefelhaltigen Gases zwischen 8•10⁴ und 9•10⁴ Pa liegt.

7. Verfahren nach einem der Ansprüche 1 - 6, wobei die Wechselwirkungszeit in Schritt (e) zwischen 30 und 240 min, vorzugsweise zwischen 150 und 200 min beträgt.

8. Verfahren nach einem der Ansprüche 1 - 7, wobei die Kohlenstoffnanoröhren in Schritt (a) unter Verwendung eines Plasmadampfabscheidungs-Spitzenwachstumsverfahrens gezüchtet werden, das die folgenden Schritte umfasst:
i) Anordnen des leitfähigen Metallsubstrats (25) auf einem geerdeten leitfähigen Substrathalter (22) in der Verarbeitungskammer (21);
ii) Evakuieren der Verarbeitungskammer (21), um einen Druck unter 10 Pa zu erhalten;
iii) Zuführen eines kohlenstoffhaltigen Gases (26) zu der Verarbeitungskammer, um einen Partialdruck des kohlenstoffhaltigen Gases innerhalb der Verarbeitungskammer (21) von 10 Pa bis 1000 Pa zu erhalten;
iv) Erzeugen eines Plasmas innerhalb der Verarbeitungskammer unter Verwendung eines Hochfrequenz-Plasmagenerators (23);
v) Ermöglichen der Wechselwirkung des Plasmas innerhalb der Verarbeitungskammer (21) mit dem leitfähigen Metallsubstrat (25), um ein Wachstum der Kohlenstoffnanoröhren auf dem leitfähigen Metallsubstrat in einer Richtung senkrecht zu der Oberfläche des leitfähigen Metallsubstrats zu ermöglichen, wobei jede Kohlenstoffnanoröhre nur ein an ihrer Spitze angeordnetes einkristallines Metallnanopartikel aufweist;
vi) Ausschalten des Hochfrequenz-Plasmagenerators (23);
vii) Sicherstellen, dass die Temperatur des leitfähigen Substrathalters (22) unter einen Schwellenwert, vorzugsweise unter 35 °C, fällt; und
viii) Entlüften der Verarbeitungskammer (21) auf Atmosphärendruck.

9. Verfahren nach Anspruch 8, wobei der in Schritt (iv) angewendete Hochfrequenz-Plasmagenerator (23), vorzugsweise ein Radiofrequenz-(RF)-Plasmagenerator, vorzugsweise unter Verwendung einer induktiven Kopplung an eine leitfähige Metallspule (24), vorzugsweise eine Kupferspule, gekoppelt ist, die um die Verarbeitungskammer (21) gewickelt ist.

10. Verfahren nach Anspruch 8 oder 9, wobei das Wachstum der Kohlenstoffnanoröhren in Schritt (v) kontinuierlich für eine Dauer von 1 bis 30 min, vorzugsweise etwa 4 min, ausgeführt wird.

11. Verfahren nach einem der Ansprüche 8 -10, wobei das in Schritt (iii) angewendete kohlenstoffhaltige Gas (26) aus der Gruppe ausgewählt ist, die aus Methan, Kohlendioxid, Ethylen und Acetylen besteht, wobei das kohlenstoffhaltige Gas (26) vorzugsweise Methan ist, besonders bevorzugt Methan mit einer Reinheit von mehr als 99 %, wobei der Partialdruck des Methans innerhalb der Verarbeitungskammer (21) nach der Methanzufuhr zwischen 20 und 60 Pa liegt.

12. Verfahren nach einem der Ansprüche 8 - 11, wobei das Plasma innerhalb der Verarbeitungskammer (21) mit hoher Leistung, vorzugsweise zwischen 500-1000 W, erzeugt wird.

13. Hybride bindemittelfreie Elektrode für elektrochemische Energiespeichervorrichtungen, die durch das Verfahren nach einem der Ansprüche 1 - 12 erhalten wird, wobei die besagte hybride bindemittelfreie Elektrode ein leitfähiges Metallsubstrat mit daran befestigten Kohlenstoffnanoröhren mit einer durchschnittlichen Länge von vorzugsweise 1 bis 2 µm und einem durchschnittlichen Durchmesser von vorzugsweise 50 bis 100 nm umfasst, vorzugsweise daraus besteht, wobei jede Kohlenstoffnanoröhre nur ein an ihrer Spitze angeordnetes einkristallines Metallnanopartikel mit einer Metallsulfidschicht auf dem einkristallinen Metallnanopartikel aufweist,
wobei die Kohlenstoffnanoröhren in eine Richtung senkrecht zu der Oberfläche des leitfähigen Metallsubstrats weisen,
wobei das Metall der einkristallinen Metallnanopartikel, das Metall der Metallsulfidschicht und das Metall des leitfähigen Metallsubstrats dasselbe sind, und
wobei die Metallsulfidschicht auf dem einkristallinen Metallnanopartikel vorzugsweise in Form polykristalliner Nanostrukturen vorliegt, besonders bevorzugt in Form polykristalliner Nanostrukturen mit individuellen Kristallitgrößen zwischen 20 und 50 nm.

14. Hybride bindemittelfreie Elektrode nach Anspruch 13, wobei das Metall Nickel ist und wobei das Metallsulfid Trinickeldisulfid (Ni₃S₂) ist.

15. Verwendung der hybriden bindemittelfreien Elektrode nach Anspruch 13 oder 14:
• als oder in einer negativen Elektrode für Lithium-Ionen-Batterien, wobei die besagte negative Elektrode vorzugsweise eine reversible Kapazität über 1000 mA•h•g⁻¹ nach 100 Zyklen bei einer Stromdichte von 100 mA•g⁻¹ liefert, und wobei die negative Elektrode vorzugsweise eine Langzeitstabilität besitzt, indem eine reversible Kapazität über 750 mA•h•g⁻¹ nach 500 Zyklen bei einer Stromdichte von 200 mA•g⁻¹ aufrechterhalten wird; oder
• als oder in einer Elektrode für einen Superkondensator, wobei die besagte Elektrode während eines Lade-Entlade-Zyklus bei einer Stromdichte von 2 A•g⁻¹ nach vielen Zyklen (mehr als 2000) vorzugsweise eine spezifische Kapazität von mehr als 400 C•g⁻¹ liefert, und wobei die spezifische Kapazität bei höheren Stromdichten (mehr als 10 A•g⁻¹) über 80 % der anfänglichen spezifischen Kapazität (mehr als 300 C•g⁻¹) beibehält.

## Revendications

1. Procédé de fabrication d'une électrode hybride sans liant pour dispositifs de stockage d'énergie électrochimique, ladite électrode hybride sans liant comprenant, de préférence constituée de, un substrat métallique conducteur et des nanotubes de carbone fixés au substrat métallique conducteur, où chaque nanotube de carbone n'a qu'une seule nanoparticule métallique monocristalline positionnée à sa pointe avec une couche supérieure de sulfure métallique, le procédé comprenant les étapes ultérieures suivantes:
a) développer des nanotubes de carbone, de préférence des nanotubes de carbone à parois multiples, dans une chambre de traitement (21) en utilisant un mécanisme de croissance de pointe, où chaque nanotube de carbone n'a qu'une seule nanoparticule métallique monocristalline positionnée à sa pointe, sur un substrat métallique conducteur dans une direction perpendiculaire à la surface du substrat métallique conducteur, où le métal des nanoparticules métalliques monocristallines et le métal du substrat métallique conducteur sont les mêmes ;
b) placer les nanotubes de carbone développés sur le substrat métallique conducteur (12) tel qu'obtenu à l'étape (a) dans une autre chambre de traitement (11) et évacuer ladite chambre de traitement (11) jusqu'à une pression inférieure à 100 Pa, de préférence jusqu'à une pression inférieure à 1 Pa, en utilisant une pompe à vide (16) et un manomètre (15) ;
c) fournir du gaz contenant du soufre (13) à la chambre de traitement (11) évacuée de l'étape (b) pour obtenir une pression partielle du gaz contenant du soufre comprise entre 1 Pa et 1 ▪ 10⁵ Pa ;
d) régler la température à l'intérieur de la chambre de traitement (11) entre 25 et 300 °C, de préférence entre 100 et 150 °C, à l'aide d'un élément chauffant (14) ;
e) permettre aux nanoparticules métalliques monocristallines aux pointes des nanotubes de carbone d'interagir avec le gaz contenant du soufre (13) à l'intérieur de la chambre de traitement (11), conduisant à la formation d'une couche supérieure de sulfure métallique sur les nanoparticules métalliques monocristallines ; et
f) s'assurer que la température de la chambre de traitement (11) chute en dessous d'une valeur seuil, de préférence en dessous de 35 °C, puis ventiler la chambre de traitement (11) jusqu'à la pression atmosphérique,
où aucun liant n'est appliqué pendant le processus.

2. Procédé selon la revendication 1, où la couche supérieure de sulfure métallique sur les nanoparticules métalliques monocristallines est sous la forme de nanostructures polycristallines, plus préférablement sous la forme de nanostructures polycristallines avec des tailles de cristallites individuelles comprises entre 20 et 50 nm.

3. Procédé selon la revendication 1 ou 2, où le métal du substrat métallique conducteur est catalytique pour la synthèse de nanotubes de carbone, où le métal du substrat métallique conducteur est de préférence choisi dans le groupe constitué par le nickel, le cobalt et le cuivre.

4. Procédé selon l'une quelconque des revendications 1 à 3, où le métal du substrat métallique conducteur est le nickel et où le sulfure métallique est le disulfure de trinickel (Ni₃S₂).

5. Procédé selon l'une quelconque des revendications 1 à 4, où les nanotubes de carbone ont un diamètre moyen compris entre 50 et 100 nm et une longueur moyenne comprise entre 1 et 2 µm.

6. Procédé selon l'une quelconque des revendications 1 à 5, où le gaz contenant du soufre (13) appliqué à l'étape (c) est du sulfure d'hydrogène (H₂S) et où la pression partielle du gaz contenant du soufre est comprise entre 8 ▪ 10⁴ et 9 ▪ 10⁴ Pa.

7. Procédé selon l'une quelconque des revendications 1 à 6, où le temps d'interaction à l'étape (e) est compris entre 30 et 240 min., de préférence entre 150 et 200 min.

8. Procédé selon l'une quelconque des revendications 1 à 7, où les nanotubes de carbone sont développés à l'étape (a) en utilisant un procédé de croissance de pointe par dépôt de vapeur par plasma comprenant les étapes suivantes :
i) disposer le substrat métallique conducteur (25) sur un support de substrat conducteur mis à la terre (22) dans la chambre de traitement (21) ;
ii) évacuer la chambre de traitement (21) pour obtenir une pression inférieure à 10 Pa ;
iii) fournir un gaz contenant du carbone (26) dans la chambre de traitement pour obtenir une pression partielle du gaz contenant du carbone à l'intérieur de la chambre de traitement (21) comprise entre 10 Pa et 1000 Pa ;
iv) créer un plasma à l'intérieur de la chambre de traitement en utilisant un générateur de plasma haute fréquence (23) ;
v) permettre au plasma à l'intérieur de la chambre de traitement (21) d'interagir avec le substrat métallique conducteur (25) pour permettre le développement des nanotubes de carbone sur le substrat métallique conducteur dans une direction perpendiculaire à la surface du substrat métallique conducteur, où chaque nanotube de carbone n'a qu'une seule nanoparticule métallique monocristalline positionnée à sa pointe ;
vi) éteindre le générateur de plasma haute fréquence (23) ;
vii) s'assurer que la température du support de substrat conducteur (22) chute en dessous d'une valeur seuil, de préférence en dessous de 35°C ; et
viii) ventiler la chambre de traitement (21) jusqu'à la pression atmosphérique.

9. Procédé selon la revendication 8, où le générateur de plasma haute fréquence (23), de préférence un générateur de plasma radiofréquence (RF), appliqué à l'étape (iv) est couplé, de préférence en utilisant le couplage inductif, à une bobine métallique conductrice (24), de préférence une bobine de cuivre, enroulée autour de la chambre de traitement (21).

10. Procédé selon la revendication 8 ou 9, où la croissance des nanotubes de carbone à l'étape (v) est effectuée en continu pendant une durée comprise entre 1 et 30 min, de préférence environ 4 min.

11. Procédé selon l'une quelconque des revendications 8 à 10, où le gaz contenant du carbone (26) appliqué à l'étape (iii) est sélectionné dans le groupe constitué par le méthane, le dioxyde de carbone, l'éthylène et l'acétylène, où le gaz contenant du carbone (26) est de préférence du méthane, plus préférablement du méthane avec une pureté supérieure à 99%, où la pression partielle du méthane à l'intérieur de la chambre de traitement (21) est comprise entre 20 et 60 Pa après l'alimentation en méthane.

12. Procédé selon l'une quelconque des revendications 8 à 11, où le plasma à l'intérieur de la chambre de traitement (21) est créé à une puissance élevée, de préférence entre 500 et 1000 W.

13. Électrode hybride sans liant pour dispositifs de stockage d'énergie électrochimique obtenue par le procédé selon l'une quelconque des revendications 1 à 12, ladite électrode hybride sans liant comprenant, de préférence constituée de, un substrat métallique conducteur avec des nanotubes de carbone ayant une longueur moyenne de préférence de 1 à 2 µm et un diamètre moyen de préférence de 50 à 100 nm fixés à celui-ci, où chaque nanotube de carbone n'a qu'une seule nanoparticule métallique monocristalline positionnée à sa pointe avec une couche de sulfure métallique au-dessus de la nanoparticule métallique monocristalline,
où les nanotubes de carbone pointent dans une direction perpendiculaire à la surface du substrat métallique conducteur,
où le métal des nanoparticules métalliques monocristallines, le métal de la couche de sulfure métallique et le métal du substrat métallique conducteur sont les mêmes, et
où la couche de sulfure métallique sur la nanoparticule métallique monocristalline est de préférence sous la forme de nanostructures polycristallines, plus préférablement sous la forme de nanostructures polycristallines avec des tailles de cristallites individuelles comprises entre 20 et 50 nm.

14. Électrode hybride sans liant selon la revendication 13, où le métal est du nickel et où le sulfure métallique est du disulfure de trinickel (Ni₃S₂).

15. Utilisation de l'électrode hybride sans liant selon la revendication 13 ou 14 :
▪ comme ou dans une électrode négative pour batteries lithium-ion, où ladite électrode négative fournit de préférence une capacité réversible supérieure à 1000 mA▪h▪g⁻¹ après 100 cycles à une densité de courant de 100 mA▪g⁻¹, et où l'électrode négative possède de préférence une stabilité à long terme en maintenant une capacité réversible supérieure à 750 mA▪h▪g⁻¹ après 500 cycles à une densité de courant de 200 mA▪g⁻¹, ou
▪ comme ou dans une électrode pour un supercondensateur, où, pendant un cycle de charge-décharge à une densité de courant de 2 A▪g⁻¹, ladite électrode après de nombreux cycles (plus de 2000) fournit de préférence une capacité spécifique de plus de 400 C▪g⁻¹, et où la capacité spécifique conserve plus de 80 % de la capacité spécifique initiale (plus de 300 C▪g⁻¹) à des densités de courant plus élevées (plus de 10 A▪g⁻¹).
